# EUROPEAN PATENT SPECIFICATION

(11) **EP 3 229 187 B1**
(45) Date of publication and mention of the grant of the patent: **12.08.2020**
(21) Application number: 17164590.6
(22) Date of filing: 03.04.2017
(51) Int. Cl.: B64F 5/60, G06Q 10/06, G06Q 50/30

(54) **ON-BOARD STRUCTURAL LOAD ASSESSMENT OF AN AIRCRAFT DURING FLIGHT EVENTS**
BORDEIGENE STRUKTURELLE LASTBEURTEILUNG EINES FLUGZEUGES WÄHREND FLUGEREIGNISSEN
ÉVALUATION DE CHARGE STRUCTURELLE À BORD D'UN AVION PENDANT DES ÉVÉNEMENTS DE VOL

(30) Priority: 04.04.2016 US 201615090326
(43) Date of publication of application: 11.10.2017
(73) Proprietor: The Boeing Company, Chicago, IL 60606-1596 (US)
(72) Inventor: KEARNS, Justin D., Huntington Beach, CA California 92647 (US); LI, Rongsheng, Huntington Beach, CA California 92647 (US); HUSSAIN, Naveed, Huntington Beach, CA California 92647 (US); ARIWODOLA, Kayode T., Huntington Beach, CA California 92647 (US); DAVIS, Christopher L., Huntington Beach, CA California 92647 (US); HAGELIN, Jack S., Huntington Beach, CA California 92647 (US); PADO, Lawrence E., Huntington Beach, CA California 92647 (US)
(74) Representative: Howson, Richard Giles Bentham

(56) References cited:
- EP-A2- 2 682 836
- WO-A1-2014/093670
- WO-A1-2015/131193

## Description

### TECHNOLOGICAL FIELD

The present disclosure relates generally to assessing structural loads of an aircraft (and other aerospace vehicles) and, in particular, to determining the structural severity of ground or flight events on the aircraft.

### BACKGROUND

Regularly-scheduled maintenance of aircraft and other similar manufactured products have both operational and economic impacts on the daily business affairs of the overall aircraft fleet. It is important to precisely determine desired times or intervals for performing maintenance tasks to efficiently run an airline. Undesirably, unscheduled maintenance tasks can disrupt operational schedules as a result of misdiagnosing the impact or severity of a ground or flight event on an aircraft (e.g., misdiagnosing a hard landing of an aircraft) or an inability to efficiently monitor the structural health of the aircraft.

In particular, misdiagnosed hard landings may significantly impact aircraft dispatch reliability as the inspection process for assessing damage of an allegedly heavy or hard landing event is both time consuming and costly. Empirical evidence shows that, depending on the platform, 90% of pilot-initiated hard landing inspections result in no signs of damage which resultantly causes a loss of revenue due to the down-time of the aircraft. Therefore, it is desirable to have a system and method that reduces unnecessary inspections by improving upon existing practices.

WO 2014/093670 A1 discloses a method of analyzing flight data using a predictive model. WO 2015/131193 A1 discloses a system and method for virtual load monitoring of an aircraft to determine a component retirement time.

EP 2682836 A2 discloses a method for performing diagnostics of a structure subject to loads, in particular an aircraft structure.

### BRIEF SUMMARY

In a first aspect of the invention there is provided an apparatus for structural load assessment of an aircraft, the apparatus as defined in claim 1 of the appended claims. In a second aspect there is provided a method for structural load assessment of an aircraft, the method as defined in appended claim 7. In a third aspect there is provided a computer-readable storage medium as defined in appended claim 11.

Example implementations of the present disclosure are directed to an improved system, method and computer-readable storage medium for structural load assessment of an aircraft. In particular, as opposed to subjective determinations or assessments, the system utilizes machine learning techniques and structural dynamics models for accurately assessing the impact of ground or flight events on an aircraft, based at least in part on flight parameters obtained during the ground or flight event. The system may then automatically perform or trigger maintenance activities as required for the aircraft.

In particular, the system may be configured to quickly and efficiently detect structural damage within an aircraft for ensuring the safety thereof. The system may reduce false alarms that cause unnecessary service interruptions and expensive maintenance actions. Accordingly, the system may maximize the use of available ground and flight load information for implementing a high probability of detecting structural damage within an aircraft while maintaining a low false alarm rate. The present disclosure includes, without limitation, the following example implementations.

In some example implementations, a method is provided for structural load assessment of an aircraft. The method may comprise receiving flight parameters related to at least one of a ground or flight event of an aircraft, and calculating a response load on the aircraft as a result of the ground or flight event. The response load may be calculated from the flight parameters using a machine learning algorithm and a structural dynamics model of the aircraft. The method may also comprise comparing the response load to a corresponding design load, and based at least in part on the comparison, determining the structural severity of the at least one ground or flight event on the aircraft. The method may also comprise automatically initiating a maintenance activity requirement for the aircraft in an instance in which the structural severity of the at least one ground or flight event causes a limit exceedance state of at least one of the aircraft or at least one structural element of the aircraft.

In some example implementations of the method of the preceding or any subsequent example implementation, or any combination thereof, calculating the response load includes calculating the response load using the machine learning algorithm comprising at least one of a Kalman filter algorithm or a heuristic algorithm, and in at least one instance updating at least one of the machine learning algorithm or the structural dynamics model based at least in part on at least one of flight test data or flight operation data.

In some example implementations of the method of any preceding or any subsequent example implementation, or any combination thereof, calculating the response load includes calculating the response load using the machine learning algorithm that is or includes a heuristic algorithm in which the heuristic algorithm is or includes at least one of an artificial neural network, Gaussian process, regression, support vector transform, classification, clustering, or principal component analysis algorithm.

In some example implementations of the method of any preceding or any subsequent example implementation, or any combination thereof, receiving the flight parameters includes receiving the flight parameters including at least one of a vertical sink rate, pitch altitude, roll angle, roll rate, drift angle, initial sink acceleration, gross weight, center of gravity, maximum vertical acceleration at or near at least one of the aircraft nose or a pilot seat, maximum vertical acceleration at the center of gravity, or ground speed of the aircraft.

In some example implementations of the method of any preceding or any subsequent example implementation, or any combination thereof, in the instance in which the structural severity of the at least one ground or flight event causes the limit exceedance state of at least one of the aircraft or at least one structural element of the aircraft, the at least one ground or flight event includes at least one of a hard landing, overweight landing, hard braking event, encounter with turbulence, extreme maneuvering, speed limit exceedance, or stall buffet condition(s) of the aircraft.

In some example implementations of the method of any preceding or any subsequent example implementation, or any combination thereof, further comprising transmitting information indicating the structural severity of the at least one ground or flight event to at least one of an external inspection system or a health monitoring system onboard the aircraft, the external inspection system and health monitoring system being configured to download the information thereto.

In some example implementations of the method of any preceding or any subsequent example implementation, or any combination thereof, receiving the flight parameters includes receiving the flight parameters from a control unit of a health monitoring system onboard the aircraft.

In some example implementations, an apparatus is provided for structural load assessment of an aircraft. The apparatus comprises a processor and a memory storing executable instructions that, in response to execution by the processor, cause the apparatus to implement a number of subsystems, such as an approximator, and analysis and maintenance engines, which may be configured to at least perform the method of any preceding example implementation, or any combination thereof.

In some example implementations of the apparatus of the preceding example implementation, at least the processor or a memory of the apparatus may be embedded in at least one of a health monitoring system onboard the aircraft, an external inspection system, database, or a portable electronic device.

In some example implementations, a computer-readable storage medium is provided for structural load assessment of an aircraft. The computer-readable storage medium is non-transitory and has computer-readable program code portions stored therein that, in response to execution by a processor, cause an apparatus to at least perform the method of any preceding example implementation, or any combination thereof.

These and other features, aspects, and advantages of the present disclosure will be apparent from a reading of the following detailed description together with the accompanying drawings, which are briefly described below. The present disclosure includes any combination of two, three, four or more features or elements set forth in this disclosure, regardless of whether such features or elements are expressly combined or otherwise recited in a specific example implementation described herein. This disclosure is intended to be read holistically such that any separable features or elements of the disclosure, in any of its aspects and example implementations, should be viewed as intended, namely to be combinable, unless the context of the disclosure clearly dictates otherwise.

It will therefore be appreciated that this Brief Summary is provided merely for purposes of summarizing some example implementations so as to provide a basic understanding of some aspects of the disclosure. Accordingly, it will be appreciated that the above described example implementations are merely examples and should not be construed to narrow the scope of the disclosure in any way. Other example implementations, aspects and advantages will become apparent from the following detailed description taken in conjunction with the accompanying drawings which illustrate, by way of example, the principles of some described example implementations.

### BRIEF DESCRIPTION OF THE DRAWING(S)

Having thus described example implementations of the disclosure in general terms, reference will now be made to the accompanying drawings, which are not necessarily drawn to scale, and wherein:
Figure 1 is an illustration of a system for structural load assessment of an aircraft, according to example implementations of the present disclosure;
Figure 2 illustrates an apparatus according to example implementations of the present disclosure.
Figure 3 is an illustration of a sample data set according to example implementations of the present disclosure;
Figure 4 illustrates a plurality of response load locations according to example implementations of the present disclosure;
Figure 5 is a plot of model load outputs according to examples implementations of the present disclosure; and
Figure 6 is a flow diagram illustrating various operations of a method for structural load assessment of an aircraft, according to example implementations of the present disclosure.

### DETAILED DESCRIPTION

Some implementations of the present disclosure will now be described more fully hereinafter with reference to the accompanying drawings, in which some, but not all implementations of the disclosure are shown. Indeed, various implementations of the disclosure may be embodied in many different forms and should not be construed as limited to the implementations set forth herein; rather, these example implementations are provided so that this disclosure will be thorough and complete, and will fully convey the scope of the disclosure to those skilled in the art. For example, unless otherwise indicated, reference to something as being a first, second or the like should not be construed to imply a particular order. Also, for example, reference may be made herein to quantitative measures, values, relationships or the like. Unless otherwise stated, any one or more if not all of these may be absolute or approximate to account for acceptable variations that may occur, such as those due to engineering tolerances or the like. Like reference numerals refer to like elements throughout.

Example implementations of the present disclosure are generally directed to assessing structural loads of an aircraft and, in particular, to determining the severity of ground or flight events on the structure of an aircraft. Example implementations will be primarily described in conjunction with aerospace applications in which the aircraft may be composed of one or more structural elements, such as one or more materials, components, assemblies and sub-assemblies. It should be understood, however, that example implementations may be utilized in conjunction with a variety of other applications, both in the aerospace industry and outside of the aerospace industry. In this regard, example implementations may be utilized in conjunction with complex systems, vehicles or the like, such as in the case of aerospace, automotive, marine and electronics. For example, while the example implementations may be discussed or illustrated herein with reference to an aircraft, the present disclosure may be applied to a number of aerospace vehicles including aircrafts, spacecraft, and other vehicles not explicitly contemplated herein.

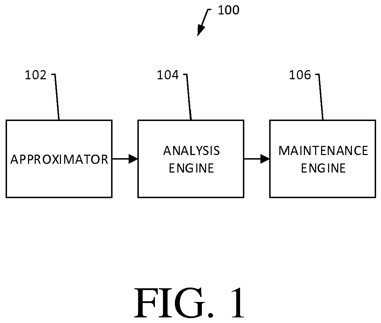

Figure 1 illustrates a system **100** for structural load assessment of an aircraft according to example implementations of the present disclosure, which may be simply referred to as the "system" herein. The system may be configured to perform a number of different functions or operations, either automatically, under direct operator control, or some combination of thereof. In this regard, the system may be configured to perform one or more of its functions or operations automatically, that is, without being directly controlled by an operator. Additionally or alternatively, the system may be configured to perform one or more of its functions or operations under direct operator control.

The system **100** may be generally configured to accurately assess structural loads on an aircraft as a result of flight events such as assessing the impact or severity of a landing on the aircraft. Among various benefits, the system may provide minimal false positive and zero false negative indications of severe flight events (e.g., hard landing, overweight landing, hard braking event, turbulence conditions, extreme maneuvering, speed limit exceedance, stall buffet conditions, and the like). The system may also increase reliability (e.g., the system utilizes machine learning algorithms and a structural dynamics model of the aircraft and does not solely rely upon measurements from sensors that may provide erroneous data or be susceptible to damage) for assessment of structural loads. The system may also provide for rapid and efficient computation of structural load assessments on-board an aircraft to determine the need for inspection. Individually or collectively these benefits may reduce the number of hours an aircraft may be off-line for inspection which in turn may save airline operators significant revenue, maintenance cost, and customer inconvenience.

The system **100** may include one or more of each of a number of different subsystems (each an individual system) coupled to one another for performing one or more functions or operations. As shown in Figure 1, for example, the system may include an approximator **102,** analysis engine **104** and/or maintenance engine **106** that may be coupled to one another. Although shown as part of the system, one or more of the approximator, analysis engine or maintenance engine may instead be separate from but in communication with the system. It should also be understood that one or more of the subsystems may function or operate as a separate system without regard to others of the subsystems. And further, it should be understood that the system may include one or more additional or alternative subsystems than those shown in Figure 1.

As explained in greater detail below, the approximator **102** may be generally configured to receive flight parameters related to a ground or flight event of an aircraft, and calculate a response load on the aircraft as a result of the ground or flight event, in which the response load may be calculated from the flight parameters using a machine learning algorithm and a structural dynamics model of the aircraft. The analysis engine **104** may be coupled to the approximator and generally configured to compare the response load to a corresponding design load, and based at least in part on the comparison, determine the structural severity of the ground or flight event on the aircraft. The maintenance engine **106** may be coupled to the analysis engine and generally configured to automatically initiate a maintenance activity requirement for the aircraft in an instance in which the structural severity of the ground or flight event causes a limit exceedance state of the aircraft or at least one structural element thereof.

According to example implementations of the present disclosure, the system **100** and its subsystems and/or components including the approximator **102,** analysis engine **104,** and/or maintenance engine **106** may be implemented by various means. Means for implementing the systems, subsystems and their respective elements may include hardware, alone or under direction of one or more computer programs from a computer-readable storage medium.

In some examples, one or more apparatuses may be provided that are configured to function as or otherwise implement the systems, subsystems, tools and respective elements shown and described herein. In examples involving more than one apparatus, the respective apparatuses may be connected to or otherwise in communication with one another in a number of different manners, such as directly or indirectly via a wired or wireless network or the like.

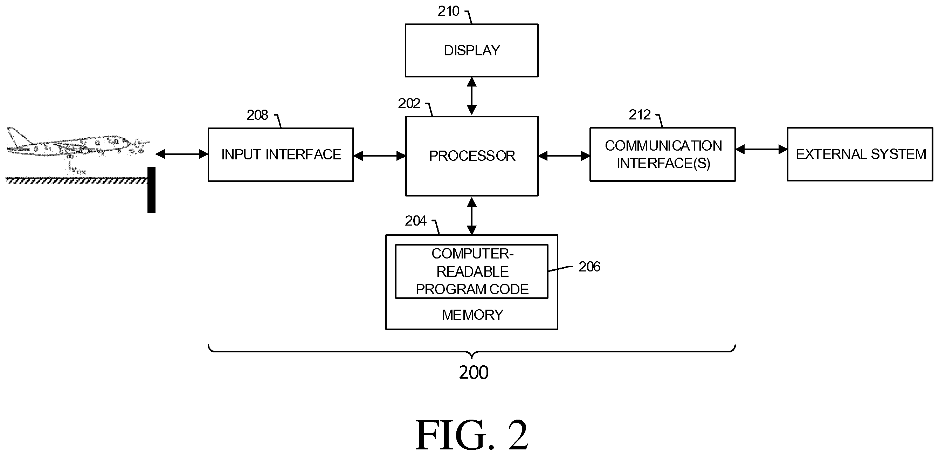

Figure 2 illustrates an apparatus **200** that may be configured to implement the system **100,** and that may be equally configured to individually implement any of its subsystems and/or components, according to some example implementations of the present disclosure. Generally, the apparatus may comprise, include or be embodied in one or more fixed or portable electronic devices (e.g., handheld mobile devices utilized by personnel of an aircraft maintenance crew), databases or a combination thereof. Examples of suitable electronic devices include an aircraft dashboard, smartphone, tablet computer, laptop computer, desktop computer, workstation computer, server computer or the like.

In more particular examples, the electronic device may be embedded in a health monitoring system onboard an aircraft, embedded in or coupled to a control unit of the health monitoring system. Or in some examples, the electronic device may be embodied in a fixed or mobile onground maintenance system coupleable (by wired or wirelessly) to the control unit of a health monitoring system onboard an aircraft. In some examples, the apparatus may be embodied within a database and/or other infrastructure which may allow further improvement of the probability of detecting structural damage and reduction of false alarms by leveraging historical data across a fleet of aircraft and across various aircraft types maintained by a ground fleet management support system.

The apparatus **200** may include one or more of each of a number of components such as, for example, a processor **202** (e.g., processor unit) connected to a memory **204** (e.g., storage device) having computer-readable program code **206** stored therein. In addition to the memory, the processor may also be connected to one or more interfaces for displaying, transmitting and/or receiving information. The interfaces may include an input interface **208,** display **210** and/or communication interface **212** (e.g., communications unit).

The input interface **208** may be configured to manually or automatically receive information such as flight parameters from an aircraft. In some examples, the input interface may be coupled or coupleable to a control unit of a health monitoring system onboard the aircraft, and through which the approximator **102** of the system **100** implemented by apparatus **200** may be configured to receive the flight parameters from the control unit. The apparatus may implement the system further including the analysis engine **104** to determine the structural severity of a ground or flight event on the aircraft based on a response load on the aircraft, which may be calculated from the flight parameters using a machine learning algorithm and a structural dynamics model of the aircraft, as indicated above and described more fully below.

In some example implementations, the display **210** may be coupled to the processor **202** and configured to display or otherwise present information indicating the structural severity of the ground or flight event. Additionally or alternatively, in some example implementations, the communication interface **212** may be coupled to the processor **202** and configured to transmit information indicating the structural severity of the ground or flight event to at least one of an external inspection system or a health monitoring system onboard the aircraft, such as in the instance in which the structural severity of the ground or flight event causes the limit exceedance state of the aircraft or at least one structural element thereof.

For example, the displayed and/or transmitted information may be or include ground and/or flight load information (e.g. landing, hard braking event, turbulence, maneuvering, speed limit exceedance, stall buffet information, and the like), which may be used to direct inspections and therefore reduce inspection cost and time. In these examples, the external inspection system and health monitoring system may be configured to download the information thereto. In some implementations, the display **210** may be embedded within a flight deck of the aircraft such that the transmitted information may be visible to a pilot or other aircraft personnel within the flight deck via the display (e.g., visible display page within the flight deck of the aircraft).

Reference is now again made to Figure 1, as indicated above, the approximator **102** may be configured to receive flight parameters related to a ground or flight event of an aircraft. In some example implementations, the approximator **102** may receive the flight parameters via an input interface (e.g., input interface **208).** In one example implementation, the input interface may be or include a user input interface through which the approximator may manually receive the flight parameters via user input.

Any of a number of different flight parameters may be suitable for example implementations of the present disclosure. Examples of suitable flight parameters may be or include at least one of a vertical sink rate, pitch altitude, roll angle, roll rate, drift angle, initial sink acceleration, gross weight, center of gravity, control surface deflections maximum vertical acceleration near the nose of the aircraft or at a pilot seat, maximum vertical acceleration at the center of gravity, or ground speed of the aircraft. In some examples, the flight parameters may include sensor data recorded during a flight, including the ground or flight event, by various sensors and systems. In these example implementations, the flight parameters may be received automatically via the various sensors and systems. Examples of suitable sensors and systems include Avionics systems, Flight Controls systems, and/or other Flight Operations or Maintenance Operations systems or components thereof. Examples of suitable sensor data in addition to flight parameters may include strains and accelerations measured at key locations on the aircraft.

In some example implementations, the flight parameters may be recorded with appropriate sample rates for resolving proper peak values during a ground or flight event (e.g., landing, side or drag, turbulence, maneuvering, speed limit exceedance, stall buffet, and the like). For example, the flight parameters may be recorded at a minimum of eight (8) samples per second. In these example implementations, higher sampling rates may correlate to more accurate peak information being captured from the time varying flight parameter information. It should be noted that although flight parameters may be recorded in real-time during a ground or flight event, various functions of the system may be executed in real-time or after an occurrence of the ground or flight event (e.g., after touchdown during a landing).

In these implementations, the approximator **102** may process the flight parameters and return a single value or reduced set of values of one or more of the flight parameter recorded during the ground or flight event (e.g., touchdown during a landing). The single value or reduced set of values, in some instances, may be based at least in part on a maximum and/or minimum value of the flight parameter recorded during the ground or flight event. For example, the approximator may identify maximum or peak values of the flight parameters (e.g., left and right gear truck tilt, normal acceleration at center of gravity, rate of sink, pitch angle, roll angle, roll rate, drift angle,, gross weight, center of gravity, normal acceleration at cockpit, equivalent airspeed, and the like) during the ground or flight event. In particular, in some implementations, the reduced set of values may be recorded during a specific time frame before and/or after the ground or flight event.

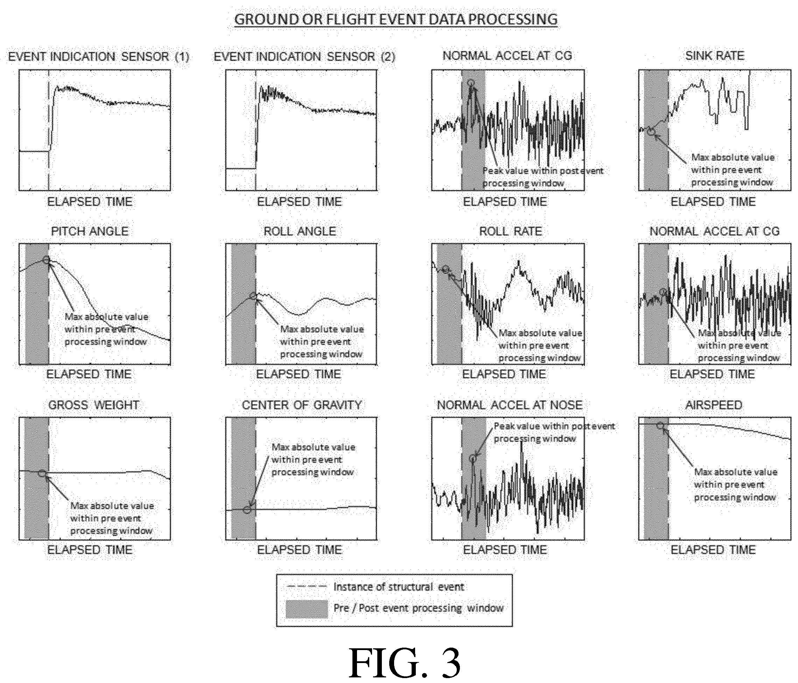

Figure 3 illustrates an example of a reduced set of values recorded during the touchdown of an aircraft in which the reduced set of values may be utilized as flight parameters for assessing the structural severity of the touchdown event on the aircraft. For example, Figure 3 illustrates a plurality of flight parameters recorded during a flight in which the reduced data set corresponds to the values of the flight parameters recorded during a specific time frame with respect to a first instance in time of the touchdown event. Within the time frame (e.g., post touchdown window, pre touchdown window, or the like), the maximum or peak values of the flight parameters may be identified.

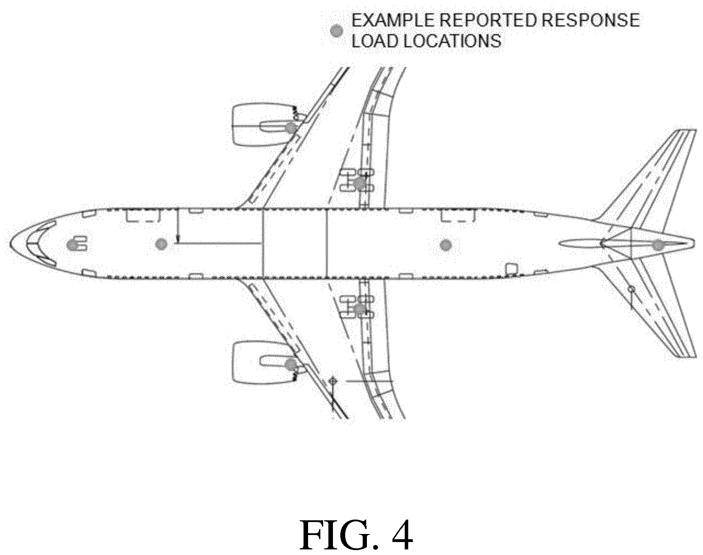

As indicated above, the approximator **102** may be configured to calculate the response load on the aircraft as a result of the ground or flight event. The response load may be calculated from the flight parameters and using a machine learning algorithm and a structural dynamics model of the aircraft, and in some examples may include one or more response loads at respective key distinct locations, as shown in Figure 4. In some examples, the machine learning algorithm may be trained based at least in part on example input and output data sets that may be analytically (e.g., using a numerical simulation) and/or experimentally (e.g., using flight test data) derived. Further in some examples, the structural dynamics model may be or include a model generated based on one or more physics laws and may be periodically updated for improvement using at least one of flight test and/or flight operation data.

In at least one instance, the approximator **102** may be configured to update (e.g., automatically or in response to a manual trigger) at least one of the machine learning algorithm or structural dynamics model based at least in part on flight test data or flight operation data that may be maintained in a database as an integral part of the aircraft service system. In particular, the model may be generated, periodically updated, and verified from flight tests as well as historical flight data which may be stored and maintained in a database including architectural elements of the system conceived using processes described herein.

In some examples, the machine learning algorithm may be or include a Kalman filter algorithm and/or a heuristic algorithm. In these examples, the heuristic algorithm may be or include at least one of an artificial neural network, Gaussian process, regression, support vector transform, classification, clustering, principal component analysis algorithm, or the like. Other suitable heuristic algorithms include heuristic modeling techniques as disclosed in U.S. Pat. Pub. No. 2008/0114506 to Davis et al. In some example implementations, the heuristic algorithm may execute a high-order nonlinear curve fitting for calculating the response load from the flight parameters.

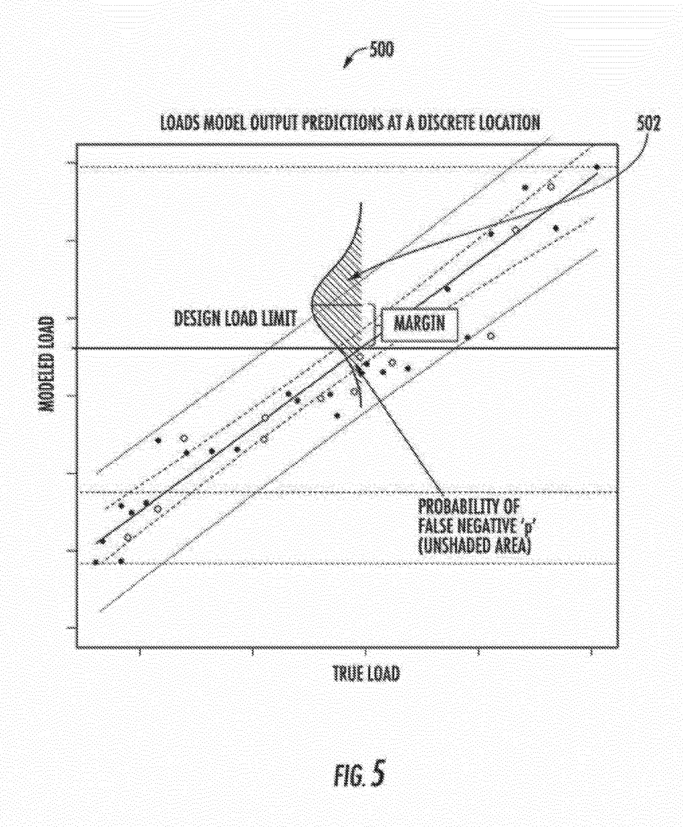

As shown in Figure 5, in some implementations, the heuristic algorithm may include a Bayesian-based probabilistic modeling technique may be configured to correct an error associated with the input data by adding a safety margin for calculated response loads. Figure 5 is an illustration of a plurality of heuristic model outputs **500** according to example implementations of the present disclosure. In particular, Figure 5 is a plot of load outputs of a number of events with applied safety margins as a function of uncertainty due to input flight parameter and model error distributions. As shown, the algorithm may be configured to correct an error associated with sensor data (flight parameters) by adding a safety margin for calculated response loads.

In the illustrated example, a load prediction error may be modeled as a Gaussian distribution **502** having a known standard deviation, in which the safety margin may be a factor that is applied to each calculated response load for subsequently eliminating a false negative indication of a structural severity on the aircraft. For example, in an instance in which the ground or flight event is a landing, the safety margin may be implemented by applying a multiplier to the output variance and adding the resulting value to the mean load output. The safety margins may account for sources of error such as machine learning uncertainty, input measurement and down-sampling errors, and the like.

In order to accomplish this, the machine learning algorithm may be developed with noisy inputs to represent flight parameter measurement error and/or sampling error. A process for developing or generating the machine learning algorithm may comprise a plurality of steps including using in-service or flight test data sets to quantify an error distribution of each input due to sampling, building the noise or error into an analytical data set for developing a reduced-order heuristic load model (e.g., Monte Carlo simulation), and passing the noisy input information to the heuristic load model for training.

Once trained, a resulting prediction interval produced by the heuristic load model may intrinsically incorporate an additional error, caused by the input error, by widening an output distribution to account for flight parameter input scatter. A factor may be computed to reduce the probability of missing a hard landing. For example, using a discrete (e.g., binomial) probability distribution function, the factor for guaranteeing zero false negatives across a fleet of 30 aircraft for 30 years with a 95% confidence may be approximately 3. In service, the measured flight parameters may be applied to the heuristic load model to compute a mean response load output. The final load output reported for structural load assessment may be or include the mean value plus the factor multiplied by sigma to account for any input error and/or model uncertainty.

The approximator 102 may also be configured to calculate a response load on the aircraft as a result of the ground or flight event in which the response load may be calculated from the flight parameters. In some example implementations, the calculation of the response load on the aircraft may be or include a prediction of the response load based at least in part on the one or more flight parameters. The approximator may be configured to provide data (e.g., calculated response loads) to the analysis engine **104** for use in subsequently determining the structural severity of the ground or flight event of the aircraft.

The analysis engine **104** may be configured to compare the response load to a corresponding design load, and based at least in part on the comparison, determine a structural severity of the ground or flight event on the aircraft. The analysis engine may be coupled to the approximator **102** and/or the maintenance engine **106.** The analysis engine may be configured to receive calculated response loads from the approximator for use in determining the structural severity of the ground or flight event on the aircraft.

In some implementations, comparing the response load to its corresponding design load or limit may include normalizing the response load with respect to the design load for determining the structural severity of the ground or flight event on the aircraft. For example, if the normalized load is greater than one (1), the analysis engine may determine that the ground or flight event severity is great enough to require structural inspection since the response load exceeded its design limit. Alternatively, if less than one (1), the analysis engine may determine that the ground or flight event has not structurally impacted the aircraft.

In some examples, the analysis engine **104** may also be configured to calculate a residual life expectancy of the aircraft or at least one structural element thereof based at least in part on the structural severity of the ground or flight event on the aircraft. In these example implementations, the analysis engine may be configured to track historic flight event loads which may reduce scheduled maintenance inspection frequency and/or extend the life of the structural elements as a result of calculating the residual life expectantly or influencing future structural design for provided cost and weight savings.

The maintenance engine **106** may be configured to automatically initiate a maintenance activity requirement for the aircraft in an instance in which the structural severity of the ground or flight event causes a limit exceedance state of the aircraft or at least one structural element thereof. In further examples, the maintenance engine may be configured to automatically perform or trigger the maintenance activity itself for the aircraft. In some example implementations, in an instance in which the structural severity of the ground or flight event causes the limit exceedance state of the aircraft or at least one structural element thereof, the ground or flight event may include at least one of a hard landing, hard braking event, overweight landing, extreme maneuvering, speed limit exceedance, encounter with turbulence, stall buffet conditions, or the like.

In some example implementations, maintenance of a structural element may include inspection that may lead to repair or replacement of the part at its various locations and/or the repair or replacement work itself. In some example implementations, the maintenance engine 106 may be configured to automatically schedule the part for removal and/or replacement based at least partially on the structural severity of the ground or flight event on the structural element. The maintenance engine may determine a need or requirement for inspection after a ground or flight event (e.g., suspected hard or overweight landing), and further identify locations at which the inspection may be required.

As previously indicated, calculated response loads may be normalized with respect to the corresponding design loads for determining the severity of the structural event on the aircraft. In these example implementations, the normalized response loads may be grouped to represent a need or requirement for inspection across a general aircraft zone such as left main landing gear, right main landing gear, left engine strut, right engine strut, auxiliary power unit, empennage, forward fuselage, aft fuselage, and the like. For example, normalized response loads of all left main landing gear response loads (e.g., left gear vertical load, left gear drag load (aft, spin-up), left gear drag load (forward, spring-back), left drag brace tension, left drag brace compression, left side brace tension, left side brace compression, left gear beam vertical load) may be utilized to represent the need or requirement for inspection of the left main gear. The same rationale may be applied to the right main gear, forward body loads, aft body loads, left and right engine, and the like.

In some example implementations, the maintenance engine **106** may be operatively coupled to a display (e.g., display **210)** configured to present to a user a Boolean flag identifying the need or requirement for maintenance or inspection within the aircraft. In these implementations, a Boolean flag may be presented for each general zone within the aircraft. For example, each aircraft inspection zones may have a corresponding line on the display in which a zero (0) or "NO" may indicate that no inspection is needed, and a one (1) or "YES" may indicate the need for maintenance or inspection within the aircraft zone.

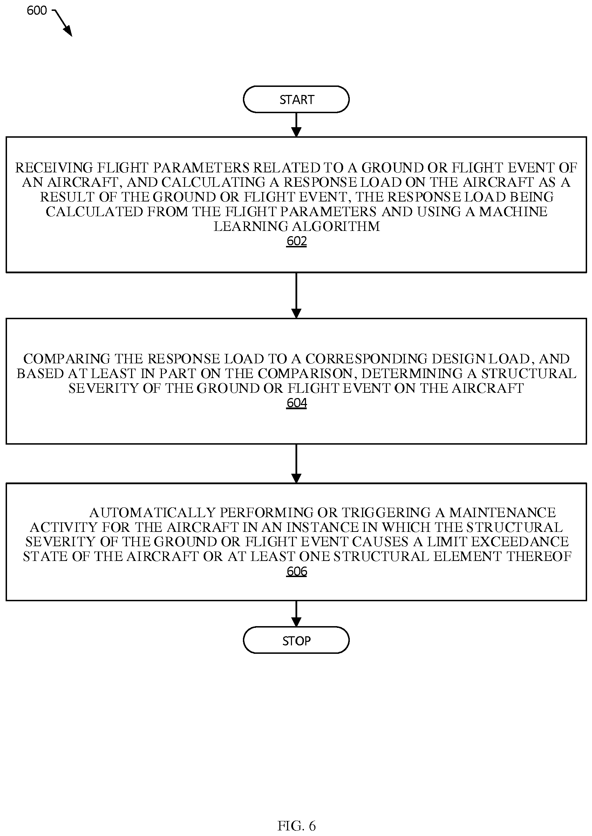

Figure 6 illustrates a flowchart including various operations of a method **600** for structural load assessment of an aircraft, in accordance with an example implementation of the present disclosure. As shown at block **602,** the method may include receiving flight parameters related to a ground or flight event of an aircraft, and calculating a response load on the aircraft as a result of the ground or flight event in which the response load may be calculated from the flight parameters using a machine learning algorithm and a structural dynamics model of the aircraft. The method may include comparing the response load to a corresponding design load, and based at least in part on the comparison, determining the structural severity of the ground or flight event on the aircraft, as shown at block **604.** The method may also include automatically performing or triggering a maintenance activity for the aircraft in an instance in which the structural severity of the ground or flight event causes a limit exceedance state of the aircraft or at least one structural element thereof, as shown in block **606.**

Reference is now again made to Figure 2, which illustrates various components of an apparatus **200** including a processor **202,** a memory **204** having computer-readable program code **206** stored therein, an input interface **208,** display **210** and/or communication interface **212.** The processor is generally any piece of computer hardware that is capable of processing information such as, for example, data, computer programs and/or other suitable electronic information. The processor is composed of a collection of electronic circuits some of which may be packaged as an integrated circuit or multiple interconnected integrated circuits (an integrated circuit at times more commonly referred to as a "chip"). The processor may be configured to execute computer programs, which may be stored onboard the processor or otherwise stored in the memory (of the same or another apparatus).

The processor **202** may be a number of processors, a multi-processor core or some other type of processor, depending on the particular implementation. Further, the processor may be implemented using a number of heterogeneous processor systems in which a main processor is present with one or more secondary processors on a single chip. As another illustrative example, the processor may be a symmetric multi-processor system containing multiple processors of the same type. In yet another example, the processor may be embodied as or otherwise include one or more application-specific integrated circuits (ASICs), field-programmable gate arrays (FPGAs) or the like. Thus, although the processor may be capable of executing a computer program to perform one or more functions, the processor of various examples may be capable of performing one or more functions without the aid of a computer program.

The memory **204** is generally any piece of computer hardware that is capable of storing information such as, for example, data, computer programs (e.g., computer-readable program code **206)** and/or other suitable information either on a temporary basis and/or a permanent basis. The memory may include volatile and/or non-volatile memory, and may be fixed or removable. Examples of suitable memory include random access memory (RAM), read-only memory (ROM), a hard drive, a flash memory, a thumb drive, a removable computer diskette, an optical disk, a magnetic tape or some combination of the above. Optical disks may include compact disk - read only memory (CD-ROM), compact disk - read/write (CD-R/W), DVD or the like. In various instances, the memory may be referred to as a computer-readable storage medium. The computer-readable storage medium is a non-transitory device capable of storing information, and is distinguishable from computer-readable transmission media such as electronic transitory signals capable of carrying information from one location to another. Computer-readable medium as described herein may generally refer to a computer-readable storage medium or computer-readable transmission medium.

The communication interface **208** may be configured to transmit and/or receive information, such as to and/or from other apparatus(es), network(s) or the like. The communication interface may be configured to transmit and/or receive information by physical (wired) and/or wireless communications links. Examples of suitable communication interfaces include a network interface controller (NIC), wireless NIC (WNIC) or the like.

The display **210** may be configured to present or otherwise display information to a user, suitable examples of which include a liquid crystal display (LCD), light-emitting diode display (LED), plasma display panel (PDP) or the like.

The input interface **212** may be wired or wireless, and may be configured to receive information from a user into the apparatus, such as for processing, storage and/or display. Suitable examples of user input interfaces include a microphone, image or video capture device, keyboard or keypad, joystick, touch-sensitive surface (separate from or integrated into a touchscreen), biometric sensor or the like. The user interfaces may further include one or more interfaces for communicating with peripherals such as printers, scanners or the like.

As indicated above, program code instructions may be stored in memory, and executed by a processor, to implement functions of the systems, subsystems and their respective elements described herein. As will be appreciated, any suitable program code instructions may be loaded onto a computer or other programmable apparatus from a computer-readable storage medium to produce a particular machine, such that the particular machine becomes a means for implementing the functions specified herein. These program code instructions may also be stored in a computer-readable storage medium that can direct a computer, a processor or other programmable apparatus to function in a particular manner to thereby generate a particular machine or particular article of manufacture. The instructions stored in the computer-readable storage medium may produce an article of manufacture, where the article of manufacture becomes a means for implementing functions described herein. The program code instructions may be retrieved from a computer-readable storage medium and loaded into a computer, processor or other programmable apparatus to configure the computer, processor or other programmable apparatus to execute operations to be performed on or by the computer, processor or other programmable apparatus.

Retrieval, loading and execution of the program code instructions may be performed sequentially such that one instruction is retrieved, loaded and executed at a time. In some example implementations, retrieval, loading and/or execution may be performed in parallel such that multiple instructions are retrieved, loaded, and/or executed together. Execution of the program code instructions may produce a computer-implemented process such that the instructions executed by the computer, processor or other programmable apparatus provide operations for implementing functions described herein.

Execution of instructions by a processor, or storage of instructions in a computer-readable storage medium, supports combinations of operations for performing the specified functions. In this manner, an apparatus **200** may include a processor **202** and a computer-readable storage medium or memory **204** coupled to the processor, where the processor is configured to execute computer-readable program code **206** stored in the memory. It will also be understood that one or more functions, and combinations of functions, may be implemented by special purpose hardware-based computer systems and/or processors which perform the specified functions, or combinations of special purpose hardware and program code instructions.

Many modifications and other implementations of the disclosure set forth herein will come to mind to one skilled in the art to which the disclosure pertains having the benefit of the teachings presented in the foregoing description and the associated drawings. Therefore, it is to be understood that the disclosure is not to be limited to the specific implementations disclosed and that modifications and other implementations are intended to be included within the scope of the appended claims. Moreover, although the foregoing description and the associated drawings describe example implementations in the context of certain example combinations of elements and/or functions, it should be appreciated that different combinations of elements and/or functions may be provided by alternative implementations without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. An apparatus (200) for structural load assessment of an aircraft, the apparatus (200) comprising a processor (202) and a memory (204) storing executable instructions that, in response to execution by the processor (202), cause the apparatus (200) to:
receive (602) flight parameters related to at least one of a ground event or a flight event of the aircraft, wherein the flight parameters include data recorded by one or more sensors during the at least one ground or flight event, wherein the received flight parameters include at least one of a vertical sink rate, pitch altitude, roll angle, roll rate, drift angle, initial sink acceleration, gross weight, center of gravity, control surface deflections, maximum vertical acceleration at or near at least one of a nose of the aircraft or a pilot seat, maximum longitudinal, lateral, and vertical acceleration at the center of gravity, airspeed, or ground speed of the aircraft;
calculate a response load on the aircraft as a result of the at least one ground event or flight event, the response load being calculated from the flight parameters and using a machine learning algorithm and a structural dynamics model of the aircraft, wherein the machine learning algorithm is configured to correct an error associated with the flight parameters by adding a predetermined safety margin for the calculated response load;
update at least one of the machine learning algorithm or the structural dynamics model based at least in part on at least one of flight test data or flight operation data;
compare (604) the response load to a corresponding design load, and based at least in part on the comparison, determine structural severity of the at least one ground or flight event on the aircraft; and
automatically initiate (606) a maintenance activity requirement for the aircraft in an instance in which the structural severity of the at least one ground event or flight event causes a limit exceedance state of at least one of the aircraft or at least one structural element of the aircraft; and
display an identification of the maintenance activity requirement to a user,
the apparatus further comprising a communication interface coupled to the processor and configured to transmit information indicating the structural severity of the at least one ground or flight event to at least one of an external inspection system or a health monitoring system onboard the aircraft, the external inspection system and health monitoring system being configured to download the information thereto.

2. The apparatus of Claim 1, wherein calculating the response load includes using the machine learning algorithm comprising at least one of a Kalman filter algorithm or a heuristic algorithm.

3. The apparatus of Claim 1 or Claim 2, wherein calculating the response load includes using the machine learning algorithm that is or includes a heuristic algorithm, and the heuristic algorithm includes at least one of an artificial neural network, Gaussian process, regression, support vector transform, classification, clustering, or principal component analysis algorithm.

4. The apparatus of any of Claims 1-3, wherein in the instance in which the structural severity of the at least one ground or flight event causes the limit exceedance state of at least one of the aircraft or the at least one structural element of the aircraft, the at least one ground or flight event includes at least one of a hard landing, overweight landing, hard braking event, encounter with turbulence, extreme maneuvering, speed limit exceedance, or stall buffet condition(s) of the aircraft.

5. The apparatus of any of Claims 1-4 further comprising an input interface coupled to the processor, coupled or coupleable to a control unit of a health monitoring system onboard the aircraft, and through which an approximator is configured to receive the flight parameters from the control unit.

6. The apparatus of any of Claims 1-5, wherein at least the processor or the memory are embedded in at least one of a health monitoring system onboard the aircraft, an external inspection system, database, or a portable electronic device.

7. A method for structural load assessment of an aircraft, the method comprising:
receiving (602) flight parameters related to at least one of a ground or flight event of the aircraft, wherein the flight parameters include data recorded by one or more sensors during the at least one ground or flight event, wherein the received flight parameters include at least one of a vertical sink rate, pitch altitude, roll angle, roll rate, drift angle, initial sink acceleration, gross weight, center of gravity, control surface deflections, maximum vertical acceleration at or near at least one of a nose of the aircraft or a pilot seat, maximum longitudinal, lateral, and vertical acceleration at the center of gravity, airspeed, or ground speed of the aircraft;
calculating a response load on the aircraft as a result of the at least one ground or flight event, the response load being calculated from the flight parameters and using a machine learning algorithm and a structural dynamics model of the aircraft, wherein the machine learning algorithm is configured to correct an error associated with the flight parameters by adding a predetermined safety margin for the calculated response load;
updating at least one of the machine learning algorithm or the structural dynamics model based at least in part on at least one of flight test data or flight operation data;
comparing (604) the response load to a corresponding design load, and based at least in part on the comparison, determining a structural severity of the at least one ground or flight event on the aircraft;
automatically initiating (606) a maintenance activity requirement for the aircraft in an instance in which the structural severity of the at least one ground or flight event causes a limit exceedance state of at least one of the aircraft or at least one structural element of the aircraft;
displaying an identification of the maintenance activity requirement to a user; and
transmitting information indicating the structural severity of the at least one ground or flight event to at least one of an external inspection system or a health monitoring system onboard the aircraft, the external inspection system and health monitoring system being configured to download the information thereto.

8. The method of Claim 7, wherein calculating the response load includes using the machine learning algorithm comprising at least one of a Kalman filter algorithm or a heuristic algorithm.

9. The method of Claim 7 or Claim 8, wherein calculating the response load includes using the machine learning algorithm that is or includes a heuristic algorithm, and the heuristic algorithm includes at least one of an artificial neural network, Gaussian process, regression, support vector transform, classification, clustering, or principal component analysis algorithm.

10. The method of any of Claims 7-9, wherein in the instance in which the structural severity of the at least one ground or flight event causes the limit exceedance state of at least one of the aircraft or the at least one structural element thereof, the at least one ground or flight event includes at least one of a hard landing, overweight landing, hard braking event, encounter with turbulence, extreme maneuvering, speed limit exceedance, or stall buffet condition(s) of the aircraft.

11. A computer-readable storage medium for structural load assessment of an aircraft, the computer-readable storage medium having computer-readable program code stored therein that, in response to execution by a processor, cause an apparatus to perform the method of any of claims 7-10.

## Patentansprüche

1. Vorrichtung (200) zur strukturellen Lastbeurteilung eines Flugzeugs, wobei die Vorrichtung (200) einen Prozessor (202) und einen Speicher (204) aufweist, der ausführbare Befehle speichert, die, im Ansprechen auf die Ausführung durch den Prozessor (202), die Vorrichtung (200) veranlassen zum:
Empfangen (602) von Flugparametern, die sich auf wenigstens eines beziehen von einem Bodenereignis oder einem Flugereignis des Flugzeugs, wobei die Flugparameter Daten aufweisen, die von einem oder mehreren Sensoren während des wenigstens einen Boden- oder Flugereignisses aufgezeichnet werden, wobei die empfangenen Flugparameter wenigstens eines aufweisen von vertikaler Sinkrate, Steigungshöhe, Rollwinkel, Rollrate, Driftwinkel, Anfangssinkbeschleunigung, Gesamtfluggewicht, Schwerpunkt, Steuerflächenablenkungen, maximaler vertikaler Beschleunigung an oder nahe wenigstens einem von einem Bug des Flugzeugs oder einem Pilotensitz, maximaler Längs-, Seiten- und Vertikalbeschleunigung am Schwerpunkt, Fluggeschwindigkeit oder Grundgeschwindigkeit des Flugzeugs;
Berechnen einer Antwortlast an dem Flugzeug als Resultat des wenigstens einen Bodenereignisses oder Flugereignisses, wobei die Antwortlast aus den Flugparametern und unter Verwendung eines Maschinenlernalgorithmus und eines strukturellen Dynamikmodells des Flugzeugs berechnet wird, wobei der Maschinenlernalgorithmus dazu konfiguriert ist, einen Fehler, der zu den Flugparametern gehört, durch Hinzufügen eines vorgegebenen Sicherheitsfaktors für die berechnete Antwortlast zu korrigieren;
Aktualisieren wenigstens eines des Maschinenlernalgorithmus oder des strukturellen Dynamikmodells basierend wenigstens teilweise auf wenigstens einem von Flugtestdaten oder Flugbetriebsdaten;
Vergleichen (604) der Antwortlast mit einer korrespondierenden Konstruktionslast und, basierend wenigstens teilweise auf dem Vergleich, Bestimmen eines strukturellen Ausmaßes des wenigstens einen Boden- oder Flugereignisses auf das Flugzeug; und
automatisches Initiieren (606) eines Wartungsaktivitätsbedarfs für das Flugzeug in einem Fall, in dem das strukturelle Ausmaß des wenigstens einen Bodenereignisses oder Flugereignisses einen Grenzwertüberschreitungszustand von wenigstens einem des Flugzeugs oder wenigstens eines strukturellen Elements des Flugzeugs verursacht; und
Anzeigen einer Identifizierung des Wartungsaktivitätsbedarfs für einen Benutzer,
wobei die Vorrichtung des Weiteren eine Kommunikationsschnittstelle aufweist, die mit dem Prozessor verbunden und dazu konfiguriert ist, Informationen, die das strukturellen Ausmaß des wenigstens einen Boden- oder Flugereignisses angeben, an wenigstens eines zu senden von einem externen Inspektionssystem oder einem Zustandsüberwachungssystem an Bord des Flugzeugs, wobei das externe Inspektionssystem und das Zustandsüberwachungssystem dazu konfiguriert sind, die Informationen darauf herunterzuladen.

2. Vorrichtung nach Anspruch 1, wobei das Berechnen der Antwortlast das Verwenden des Maschinenlernalgorithmus aufweist, der wenigstens eines aufweist von einem Kalmanfilteralgorithmus oder einem heuristischen Algorithmus.

3. Vorrichtung nach Anspruch 1 oder Anspruch 2, wobei das Berechnen der Antwortlast das Verwenden des Maschinenlernalgorithmus aufweist, der ein heuristischer Algorithmus ist oder einen heuristischen Algorithmus aufweist, und wobei der heuristische Algorithmus wenigstens eines aufweist von einem künstlichen neuronalen Netzwerk, einem Gauß-Prozess, Regression, Support Vector Transformation, Klassifizierung, Clusterbildung oder Hauptkomponentenanalyse-Algorithmus.

4. Vorrichtung nach einem der Ansprüche 1-3, wobei in dem Fall, bei dem das strukturelle Ausmaß des wenigstens einen Boden- oder Flugereignisses den Grenzwertüberschreitungszustand von wenigstens einem des Flugzeugs oder des wenigstens einen strukturellen Elements des Flugzeugs verursacht, das wenigstens eine Boden- oder Flugereignis wenigstens eines aufweist von einer harten Landung, Landung mit Übergewicht, einem scharfen Bremsereignis, Treffen auf Turbulenzen, extremem Manövrieren, Geschwindigkeitsüberschreitung oder Bedingung(en) eines Schlags auf das Flugzeug durch Abreißen der Strömung.

5. Vorrichtung nach einem der Ansprüche 1-4, die des Weiteren eine Eingangsschnittstelle aufweist, die mit dem Prozessor verbunden ist, mit einer Steuereinheit eines Zustandsüberwachungssystems an Bord des Flugzeugs verbunden oder verbindbar ist, und durch welche ein Approximator dazu konfiguriert ist, die Flugparameter von der Steuereinheit zu empfangen.

6. Vorrichtung nach einem der Ansprüche 1-5, wobei wenigstens der Prozessor oder der Speicher in wenigstens einem eingebettet sind von einem Zustandsüberwachungssystem an Bord des Flugzeugs, einem externen Inspektionssystem, einer Datenbank oder einem tragbaren elektronischen Gerät.

7. Verfahren zur strukturellen Lastbeurteilung eines Flugzeugs, wobei das Verfahren aufweist:
Empfangen (602) von Flugparametern, die sich auf wenigstens eines beziehen von einem Bodenereignis oder einem Flugereignis des Flugzeugs, wobei die Flugparameter Daten aufweisen, die von einem oder mehreren Sensoren während des wenigstens einen Boden- oder Flugereignisses aufgezeichnet werden, wobei die empfangenen Flugparameter wenigstens eines aufweisen von vertikaler Sinkrate, Steigungshöhe, Rollwinkel, Rollrate, Driftwinkel, Anfangssinkbeschleunigung, Gesamtfluggewicht, Schwerpunkt, Steuerflächenablenkungen, maximaler vertikaler Beschleunigung an oder nahe wenigstens einem von einem Bug des Flugzeugs oder einem Pilotensitz, maximaler Längs-, Seiten- und Vertikalbeschleunigung am Schwerpunkt, Fluggeschwindigkeit oder Grundgeschwindigkeit des Flugzeugs;
Berechnen einer Antwortlast an dem Flugzeug als Resultat des wenigstens einen Bodenereignisses oder Flugereignisses, wobei die Antwortlast aus den Flugparametern und unter Verwendung eines Maschinenlernalgorithmus und eines strukturellen Dynamikmodells des Flugzeugs berechnet wird, wobei der Maschinenlernalgorithmus dazu konfiguriert ist, einen Fehler, der zu den Flugparametern gehört, durch Hinzufügen eines vorgegebenen Sicherheitsfaktors für die berechnete Antwortlast zu korrigieren;
Aktualisieren wenigstens eines des Maschinenlernalgorithmus oder des strukturellen Dynamikmodells basierend wenigstens teilweise auf wenigstens einem von Flugtestdaten oder Flugbetriebsdaten;
Vergleichen (604) der Antwortlast mit einer korrespondierenden Konstruktionslast und, basierend wenigstens teilweise auf dem Vergleich, Bestimmen eines strukturellen Ausmaßes des wenigstens einen Boden- oder Flugereignisses auf das Flugzeug;
automatisches Initiieren (606) eines Wartungsaktivitätsbedarfs für das Flugzeug in einem Fall, in dem das strukturelle Ausmaß des wenigstens einen Bodenereignisses oder Flugereignisses einen Grenzwertüberschreitungszustand von wenigstens einem des Flugzeugs oder wenigstens eines strukturellen Elements des Flugzeugs verursacht; und
Anzeigen einer Identifizierung des Wartungsaktivitätsbedarfs für einen Benutzer; und
Senden von Informationen, die das strukturelle Ausmaß des wenigstens einen Boden- oder Flugereignisses angeben, an wenigstens eines von einem externen Inspektionssystem oder einem Zustandsüberwachungssystem an Bord des Flugzeugs, wobei das externe Inspektionssystem und das Zustandsüberwachungssystem dazu konfiguriert sind, die Informationen darauf herunterzuladen.

8. Verfahren nach Anspruch 7, wobei das Berechnen der Antwortlast das Verwenden des Maschinenlernalgorithmus aufweist, der wenigstens eines aufweist von einem Kalmanfilteralgorithmus oder einem heuristischen Algorithmus.

9. Verfahren nach Anspruch 7 oder Anspruch 8, wobei das Berechnen der Antwortlast das Verwenden des Maschinenlernalgorithmus aufweist, der ein heuristischer Algorithmus ist oder einen heuristischen Algorithmus aufweist, und wobei der heuristische Algorithmus wenigstens eines aufweist von einem künstlichen neuronalen Netzwerk, einem Gauß-Prozess, Regression, Support Vector Transformation, Klassifizierung, Clusterbildung oder Hauptkomponentenanalyse-Algorithmus.

10. Verfahren nach einem der Ansprüche 7-9, wobei in dem Fall, bei dem das strukturelle Ausmaß des wenigstens einen Boden- oder Flugereignisses den Grenzwertüberschreitungszustand von wenigstens einem des Flugzeugs oder des wenigstens einen strukturellen Elements davon verursacht, das wenigstens eine Boden- oder Flugereignis wenigstens eines aufweist von einer harten Landung, Landung mit Übergewicht, einem scharfen Bremsereignis, Treffen auf Turbulenzen, extremem Manövrieren, Geschwindigkeitsüberschreitung oder Bedingung(en) eines Schlags auf das Flugzeug durch Abreißen der Strömung.

11. Computerlesbares Speichermedium zur strukturellen Lastbeurteilung eines Flugzeugs, wobei das computerlesbare Speichermedium darin gespeicherten computerlesbaren Programmcode aufweist, der im Ansprechen auf die Ausführung durch einen Prozessor veranlasst, dass eine Vorrichtung das Verfahren nach einem der Ansprüche 7-10 durchführt.

## Revendications

1. Dispositif (200) pour l'évaluation de charge structurelle d'un aéronef, le dispositif (200) comprenant un processeur (202) et une mémoire (204) stockant des instructions exécutables qui, en réponse à une exécution par le processeur (202), amènent le dispositif (200) à :
recevoir (602) des paramètres de vol relatifs à au moins un élément parmi un événement au sol ou un événement en vol de l'aéronef, dans lequel les paramètres de vol comportent des données enregistrées par un ou plusieurs capteurs pendant l'au moins un événement ou sol ou en vol, dans lequel les paramètres de vol reçus comportent au moins un élément parmi un taux de chute verticale, une altitude de tangage, un angle de roulis, un taux de roulis, un angle de dérive, une accélération de chute initiale, une masse totale, un centre de gravité, des braquages de gouverne, une accélération verticale maximale au niveau ou à proximité d'au moins un élément parmi un nez de l'aéronef ou un siège de pilote, une accélération maximale longitudinale, latérale et verticale au niveau du centre de gravité, une vitesse aérodynamique, ou une vitesse sol de l'aéronef ;
calculer une charge de réponse sur l'aéronef en conséquence de l'au moins un événement au sol ou événement en vol, la charge de réponse étant calculée à partir des paramètres de vol et en utilisant un algorithme d'apprentissage automatique et un modèle de dynamique de structure de l'aéronef, dans lequel l'algorithme d'apprentissage automatique est configuré pour corriger une erreur associée aux paramètres de vol en ajoutant une marge de sécurité prédéterminée pour la charge de réponse calculée ;
mettre à jour au moins un élément parmi l'algorithme d'apprentissage automatique ou le modèle de dynamique de structure sur la base au moins en partie d'au moins une des données parmi des données d'essais en vol ou des données d'opérations en vol ;
comparer (604) la charge de réponse à une charge théorique correspondante, et sur la base au moins en partie de la comparaison, déterminer la sévérité structurelle de l'au moins un événement au sol ou en vol sur l'aéronef ; et
initier automatiquement (606) une exigence d'activité de maintenance pour l'aéronef dans le cas où la sévérité structurelle de l'au moins un événement au sol ou événement en vol provoque un état de dépassement d'une limite d'au moins un élément parmi l'aéronef ou au moins un élément structurel de l'aéronef ; et
afficher une identification de l'exigence d'activité de maintenance à un utilisateur,
le dispositif comprenant en outre une interface de communication couplée au processeur et configurée pour transmettre des informations indiquant la sévérité structurelle de l'au moins un événement au sol ou en vol à au moins un système parmi un système d'inspection externe ou un système de surveillance de l'intégrité à bord de l'aéronef, le système d'inspection externe et le système de surveillance de l'intégrité étant configurés pour télécharger les informations vers ceux-ci.

2. Dispositif selon la revendication 1, dans lequel le calcul de la charge de réponse comporte l'utilisation de l'algorithme d'apprentissage automatique comprenant au moins un algorithme parmi un algorithme de filtre de Kalman ou un algorithme heuristique.

3. Dispositif selon la revendication 1 ou la revendication 2, dans lequel le calcul de la charge de réponse comporte l'utilisation de l'algorithme d'apprentissage automatique qui est ou comporte un algorithme heuristique, et l'algorithme heuristique comporte au moins un élément parmi un réseau de neurones artificiels, un processus gaussien, une régression, une transformée de vecteur support, une classification, un regroupement, ou un algorithme d'analyse de composante principale.

4. Dispositif selon une quelconque des revendications 1 à 3, dans lequel dans le cas où la sévérité structurelle de l'au moins un événement au sol ou en vol provoque l'état de dépassement d'une limite d'au moins un élément parmi l'aéronef ou l'au moins un élément structurel de l'aéronef, l'au moins un événement au sol ou en vol comporte au moins un élément parmi un atterrissage brutal, un atterrissage en surcharge, un événement de freinage dur, une rencontre de turbulences, des manœuvres extrêmes, un dépassement d'une limite de vitesse, ou une(des) condition(s) de tremblement avertisseur de décrochage de l'aéronef.

5. Dispositif selon une quelconque des revendications 1 à 4, comprenant en outre une interface d'entrée couplée au processeur, couplé ou qui peut être couplé à une unité de commande d'un système de surveillance de l'intégrité à bord de l'aéronef, et par l'intermédiaire duquel un approximateur est configuré pour recevoir les paramètres de vol provenant de l'unité de commande.

6. Dispositif selon une quelconque des revendications 1 à 5, dans lequel au moins le processeur ou la mémoire sont intégrés dans au moins un système parmi un système de surveillance de l'intégrité à bord de l'aéronef, un système d'inspection externe, une base de données, ou un système électronique.

7. Procédé destiné à évaluer la charge structurelle d'un aéronef, le procédé comprenant :
la réception (602) des paramètres de vol relatifs à au moins un élément parmi un événement au sol ou en vol de l'aéronef, dans lequel les paramètres de vol comportent des données enregistrées par un ou plusieurs capteurs pendant l'au moins un événement au sol ou en vol, dans lequel les paramètres de vol reçus comportent au moins un élément parmi un taux de chute verticale, une altitude de tangage, un angle de roulis, un taux de roulis, un angle de dérive, une accélération de chute initiale, une masse totale, un centre de gravité, des braquages de gouverne, une accélération verticale maximale au niveau ou à proximité d'au moins un élément parmi un nez de l'aéronef ou un siège de pilote, une accélération maximale longitudinale, latérale et verticale au niveau du centre de gravité, une vitesse aérodynamique, ou une vitesse sol de l'aéronef ;
le calcul d'une charge de réponse sur l'aéronef en conséquence de l'au moins un événement au sol ou en vol, la charge de réponse étant calculée à partir des paramètres de vol et en utilisant un algorithme d'apprentissage automatique et un modèle de dynamique de structure de l'aéronef, dans lequel l'algorithme d'apprentissage automatique est configuré pour corriger une erreur associée aux paramètres de vol en ajoutant une marge de sécurité prédéterminée pour la charge de réponse calculée ;
la mise à jour d'au moins un élément parmi l'algorithme d'apprentissage automatique ou le modèle de dynamique de structure sur la base au moins en partie d'au moins une des données parmi des données d'essais en vol ou des données d'opérations en vol ;
la comparaison (604) de la charge de réponse à une charge théorique correspondante, et sur la base au moins en partie de la comparaison, la détermination d'une sévérité structurelle de l'au moins un événement au sol ou en vol sur l'aéronef ;
l'initiation automatique (606) d'une exigence d'activité de maintenance pour l'aéronef dans le cas où la sévérité structurelle de l'au moins un événement au sol ou événement en vol provoque un état de dépassement d'une limite d'au moins un élément parmi l'aéronef ou au moins un élément structurel de l'aéronef ;
l'affichage d'une identification de l'exigence d'activité de maintenance à un utilisateur ; et
la transmission d'informations indiquant la sévérité structurelle de l'au moins un événement au sol ou en vol à au moins un système parmi un système d'inspection externe ou un système de surveillance de l'intégrité à bord de l'aéronef, le système d'inspection externe et le système de surveillance de l'intégrité étant configurés pour télécharger les informations vers ceux-ci.

8. Procédé selon la revendication 7, dans lequel le calcul de la charge de réponse comporte l'utilisation de l'algorithme d'apprentissage automatique comprenant au moins un algorithme parmi un algorithme de filtre de Kalman ou un algorithme heuristique.

9. Procédé selon la revendication 7 ou la revendication 8, dans lequel le calcul de la charge de réponse comporte l'utilisation de l'algorithme d'apprentissage automatique qui est ou comporte un algorithme heuristique, et l'algorithme heuristique comporte au moins un élément parmi un réseau de neurones artificiels, un processus gaussien, une régression, une transformée de vecteur support, une classification, un regroupement, ou un algorithme d'analyse de composante principale.

10. Procédé selon une quelconque des revendications 7 à 9, dans lequel dans le cas où la sévérité structurelle de l'au moins un événement au sol ou en vol provoque l'état de dépassement d'une limite d'au moins un élément parmi l'aéronef ou l'au moins un élément structurel de celui-ci, l'au moins un événement au sol ou en vol comporte au moins un élément parmi un atterrissage brutal, un atterrissage en surcharge, un événement de freinage dur, une rencontre de turbulences, des manœuvres extrêmes, un dépassement d'une limite de vitesse, ou une(des) condition(s) de tremblement avertisseur de décrochage de l'aéronef.

11. Support de stockage lisible par un ordinateur pour l'évaluation de charge structurelle d'un aéronef, le support de stockage lisible par un ordinateur présentant un code de programme lisible par un ordinateur stocké à l'intérieur qui, en réponse à une exécution par un processeur, amène un dispositif à mettre en œuvre le procédé selon une quelconque des revendications 7 à 10.
